# EUROPEAN PATENT SPECIFICATION

(11) **EP 1 537 665 B1**
(45) Date of publication and mention of the grant of the patent: **15.10.2008**
(21) Application number: 03787549.9
(22) Date of filing: 18.08.2003
(51) Int. Cl.: H03K 17/955, H03K 17/96, G01D 5/24, B60Q 5/00

(54) **CAPACITANCE BASED HUMAN TOUCH ACTIVATION AND SWITCHING DEVICE**
KAPAZITIVE BERÜHRUNGSAKTIVIERBARE SCAHLTVORRICHTUNG
DISPOSITIF D'ACTIVATION ET DE COMMUTATION DU TOUCHER HUMAIN DE TYPE CAPACITATIF

(30) Priority: 16.08.2002 US 404018 P; 04.12.2002 US 430892 P
(43) Date of publication of application: 08.06.2005
(73) Proprietor: Intelligent Mechatronic Systems, Inc., Waterloo, Ontario N2J 1B1 (CA)
(72) Inventor: FILIPOV, Vladimir, Waterloo Ontario N2T 1A6 (CA); BHAVNANI, Jean-Pierre, Waterdown, Ontario L0R 2H4 (CA); BREZA, Emil, Beamsville, Ontario L0R 1B2 (CA); DESROCHERS, Kristopher, Kitchener, Ontario N2E 3P3 (CA); BASIR, Otman, A., Waterloo, Ontario N2T 2C6 (CA); KARRAY, Fakhreddine, Waterloo, Ontario N2T 2G4 (CA)
(74) Representative: Shanks, Andrew
(86) International application number: PCT/CA2003/001235
(87) International publication number: WO 2004/017521

(56) References cited:
- EP-A- 1 198 063
- DE-A- 4 417 827
- US-A- 5 789 827
- US-B2- 6 429 782

## Description

### BACKGROUND OF THE INVENTION

The present invention relates to a capacitance based, human touch activation device especially for use in, but not limited to, automotive applications. Many accessories inside a vehicle are activated by a switch. Examples include interior lights, headlights, radio or other entertainment systems, windshield wipers, horn, climate control, power windows, power locks and air conditioning. Current technologies rely on contact based switches that can break or wear out causing devices to be stuck in either an ON or OFF state. This can have adverse effects on the devices that are controlled by these switches. A typical situation is when the mechanical switch controlling the horn fails in an always-on state. This can cause the driver of the vehicle and drivers of other vehicles in the vicinity to be distracted and can lead to traffic accidents. The horn itself will eventually fail leading to a costly replacement.

Many of the switches in vehicles are also difficult to actuate under normal driving conditions. For example, actuating the dome light can be difficult while driving at night. Tiny switches are hard to find by feel and often require the driver to look away from the road in order to find them.

In addition there are many devices, such as vehicles or tools that require maintaining proper hand contact during operation to ensure the safety of the operator. Current systems may have only emergency deactivation switches attached elsewhere on the device or may have depression switches attached to handlebars or joysticks to allow activation of a device. Depression switches require extra pressure to be applied to the handlebars or joysticks to allow activation of a device. Depression switches require extra pressure to be applied to the handlebars or joystick by the operator and may become uncomfortable if operated for a sustained period of time.

EP 1198063 relates to an electrode located on a circuit board directly behind a dielectric plate such as a glass plate. Approach of a finger towards the plate alters the capacitance as a human body provides capacitance and there is capacitance between circuit board and the surrounding environment so forming capacitance between the electrode and the finger which is evaluated to detect a person's approach.

DE 4417827 relates to a sensor for detecting the presence of a person in a vehicle seat. At least one measurement electrode is connected to a voltage source which generates an electric field in the region of the monitor location and changes in the capacitance of the measurement electrodes are measured. At least one further reference electrode is connected to the voltage source which generates an electric field outside the immediate vicinity of the monitored position. Relative changes in the capacitances of the reference and measurement electrodes can be measured.

US 6,429,782 relates to a detection system including a switch device having a conductor forming part of the capacitor with variable capacitance dependent upon proximity of a person, and a detector for sensing variation in the capacitance and for generating an output signal indicating the proximity of the person relative to the conductor.

### SUMMARY OF THE INVENTION

According to a first aspect of the present invention there is provided a capacitance based, touch activated switching device comprising:
an electrode forming part of a capacitor, a capacitance of the capacitor changing based upon a presence or absence of an occupant adjacent the electrode;
a detection circuit measuring the capacitance of the capacitance of the capacitor; and
wherein the capacitor is part of an oscillator oscillating at a first frequency when no occupant is present adjacent the electrode, and at a second frequency different from the first frequency when the occupant is adjacent the electrode, the detection circuit activating a switch based upon a rate of change in the oscillator frequency.

According to a second aspect of the present invention there is provided a method for determining a presence of an occupant including the steps of:
a) oscillating an oscillator at a first frequency when no occupant is present adjacent an electrode and oscillating the oscillator at a second frequency different from the first frequency when the occupant is adjacent the electrode;
b) measuring a rate of change in oscillator frequency caused by the proximity of the occupant; and
c) activating a switch based upon the rate of change measured in step b).

The invention is a touch sensitive switching device intended to replace mechanical switches. A capacitance sensor is capable of sensing human touch through a layer of non-conductive material. This eliminates the need for a hole or opening to be cut into the console where the touch sensor is located. This allows the user to actuate a device such as a light simply by touching a designated location containing a sensing electrode. Furthermore, a capacitive based actuator does not affect the aesthetics of the interior of the vehicle.

Use of a capacitive sensor integrated into a handle or grip area of a device will eliminate the need for increased pressure during operation and will increase comfort of the operator. The system can be designed to allow activation of the device only while the operator is holding the control. Thus allowing for emergency deactivation and ensuring safety of the operator if the control is released.

### BRIEF DESCRIPTION OF THE DRAWINGS

Other advantages of the present invention can be understood by reference to the following detailed description when considered in connection with the accompanying drawings wherein:
Figure 1 is a high-level schematic of a capacitance based human touch activation and switching device.
Figure 2 is the activation and switching device of Figure 1 showing a more detailed schematic of a detection circuit, not within the scope of the presently claimed invention
Figure 3 illustrates the use of the activation and switching device in a vehicle steering wheel.
Figure 4 is a graph showing the operation of the activation and switching device of Figure 2.
Figure 5 illustrates the use of the activation and switching device of Figure 1 for controlling a vehicle dome light.
Figure 6 illustrates the use of the activation and switching device of Figure 1 in a joystick.
Figure 7 illustrates the use of the activation and switching device of Figure 1 in handlebars.
Figure 8 is the activation and switching device of Figure 1 showing a more detailed schematic of an embodiment of the detection circuit.
Figure 9 is a graph showing a possible operation of the activation and switching device of Figure 8, not within the scope of the presently claimed invention.

### DETAILED DESCRIPTION OF THE PREFERRED EMBODIMENTS

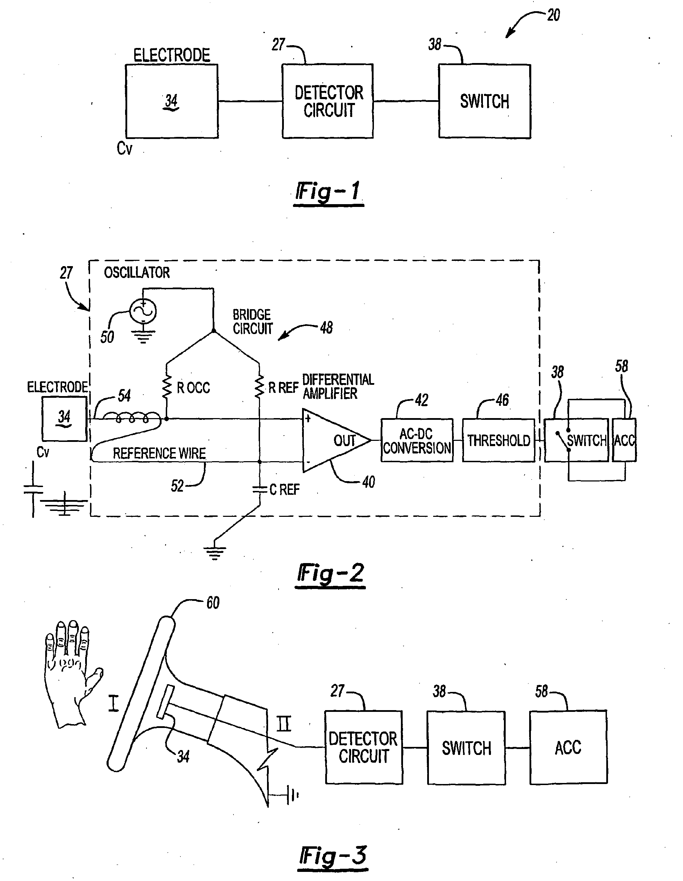

A capacitance based human touch activation and switching device 20 is shown schematically in Figure 1. Generally, a detection circuit 27 measures capacitance Cv associated with an electrode 34 as it is changed by the presence or absence of a user hand near the electrode. Based upon the capacitance or upon changes in the capacitance of the electrode 34, the detection circuit 27 activates (switches on or switches off) a switch 38. More particularly, the detection circuit 27 measures or monitors the permittivity of an area adjacent the electrode 34.

The formula for a parallel capacitor is *C*=*εA*/*d* where *C* is capacitance, ε is the permittivity, *A* is area of the plates and *d* is the distance between the plates. The values of these variables determine the capacitance of the capacitor. Therefore, a change in one or more of these variables causes a change in capacitance. The permittivity and the area of the plates are proportional to the capacitance while the distance between the plates is inversely proportional to the capacitance. This means that an increase in permittivity or area causes an increase in capacitance while a decrease in permittivity or area causes a decrease in capacitance. The opposite is true for the distance between the plates. An increase in the distance between the plates causes a decrease in capacitance while a decrease in the distance between the plates causes an increase in capacitance. The electrode 34 acts as one plate, while the surrounding environment acts as the second plate.

One detection circuit 27 that could be used in the schematic of Figure 1 is shown in FIG. 2. The detection circuit 27 includes a single differential amplifier 40 and an AC-DC conversion circuit 42 to detect changes in the voltage, current and phase of the waveform produced by the oscillator 44. A single threshold circuit 46 determines if these changes indicate the presence of an occupant. Each of the two inputs to the differential amplifier 40 is connected to one of a pair of arms in a bridge circuit 48. One arm of the bridge circuit 48 is used as a reference arm, including Rref, Cref and reference wire 52. The other arm of the bridge circuit 48 contains the electrode 34 and Rocc. An oscillator 50 is connected to both arms. Each arm of the bridge circuit 48 is essentially a low-pass filter. The reference arm of the bridge circuit 48 is tuned to have the same filter characteristics as the arm that contains the electrode 34. The change in attenuation and phase of the waveform passing through the electrode arm of the bridge circuit 48 is measured with respect to the reference arm of the bridge circuit 48. Since both arms of the bridge circuit 48 are receiving the same waveform, it does not matter if the amplitude varies slightly.

Noise rejection is accomplished by providing a second wire 52 that is connected to the reference arm of the bridge circuit 48 and twisted together with a wire 54 that connects the electrode 34 to the bridge circuit 48. Since both wires 52, 54 pick up the same noise, the noise is not amplified because it is common to both arms of the bridge circuit 48 and both inputs to the differential amplifier 40. All thresholds and signals in the device vary in proportion to the power supply voltage. As such, the device is tolerant to sudden changes in the supply voltage and will function over a wide range of supply voltages. Wire 54 may also be a coaxial cable in order to avoid noise and interference problems.

The virtual capacitor Cv, created by electrode 34 is connected in series with the resistor Rocc to form one arm of the bridge circuit 48. These are connected in parallel with the resistor Rref and the capacitor Cref which form the reference arm of the bridge circuit 48. Each arm of the bridge circuit 48 is essentially a low pass filter. The product RC determines the characteristic of each low pass filter. When RC changes, the phase and the amplitude of output of the filter changes. The RC value for the reference low pass filter is chosen so the bridge circuit 48 is balanced when no hand is present near the electrode 34. When there is a hand present near the electrode 34, Cv increases and the RC value changes in only one arm of the bridge circuit 48. The outputs of the two low pass filters are no longer the same. The unbalance in the bridge circuit 48 is detected by amplifying the differences between the two signals. The amplified signal is an AC signal representing the voltage difference between the two filters multiplied by the gain of the amplifier 40. The difference in phase shifts between the two filters is detected because the leading and lagging portions of each waveform overlap each other causing a voltage differences between theses signals. The AC signal is then passed through the AC-DC conversion circuit 42 to produce a DC signal that is then compared to a predetermined threshold in threshold detection circuit 46 to determine the presence or absence of a user hand. Based upon that determination, the detection circuit 46 switches on or off (depending upon the application) an accessory 58. As will be described below, the accessory could be any vehicle accessory, such as interior lights, headlights, radio or other entertainment systems, windshield wiper, horn, power windows, power locks and climate control.

Figure 3 illustrates the electrode 34 from Figures 1 and 2 installed in a vehicle steering wheel 60 for activating an accessory 58, such as a vehicle horn. The capacitance of the virtual capacitor Cv changes depending on the permittivity of the medium between the electrode 34 and its surroundings. When the area in front of the steering wheel 60 is empty, the medium adjacent the electrode 34 is air. Water has a higher permittivity than air and the human body consists of approximately 65% water. Hence, putting a human body part between the electrode and its surroundings will increase the permittivity and, in turn, will increase the capacitance between the electrode 34 and its surroundings. The result is the capacitance of the system (Cv) increases past the set threshold and activates the switch 38. In the event that the electrode 34 is moved to decrease or increase the distance between plates, the relative change in the capacitance will be small compared to the action of the addition of capacitance of a human body part, thus not accidentally triggering the system.

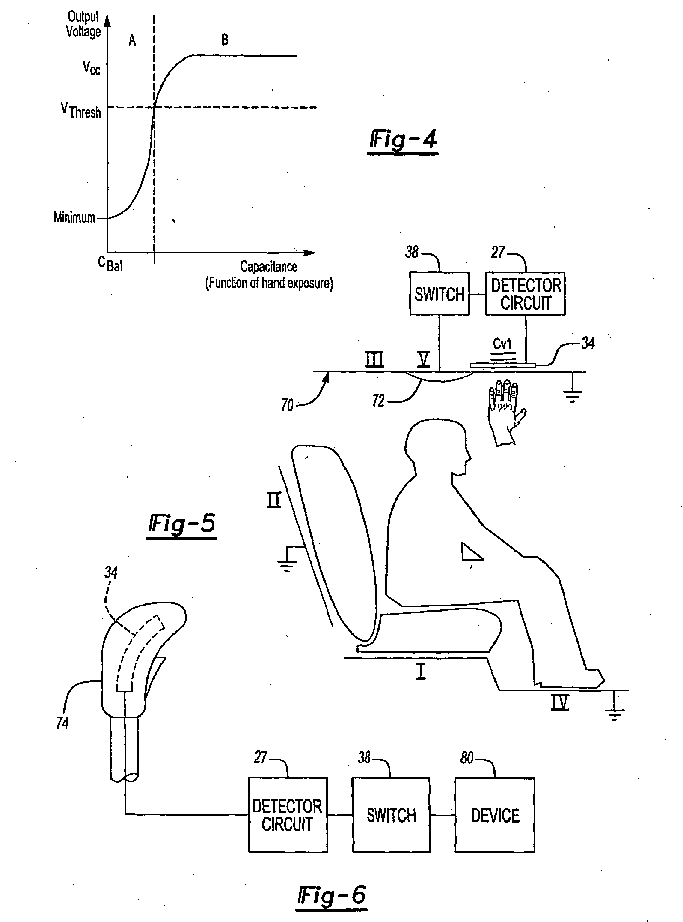

Figure 4 shows a plot of the DC output of the differential amplifier 40 versus the value of the virtual capacitance Cv. Areas A and B represent the regions of the graph that correspond to OFF and ON. In the example where the switch is used to activate a vehicle horn, Area A is the region of the graph that corresponds to OFF (a balanced bridge - no hand present) and Area B is the region of the graph that corresponds to ON (unbalanced bridge - hand present). Of course, the ON and OFF states might be reversed for other applications. The detection circuit 27 is tuned for a given environment as follows: The position of the MINIMUM of the curve is set by the value of the components in the bridge circuit Rocc, Rref and Cref. These values are tuned so that the MINIMUM point on the curve occurs at the value of Cv that corresponds to no hand present. (Cbal). The sensitivity of the device to changes in the virtual capacitance Cv is tuned by changing the gain of the differential amplifier and the predetermined threshold value Vthresh. Vthresh must be situated between the MINIMUM of the curve and the saturation voltage of the differential amplifier less a diode drop. Hysteresis may be implemented by the threshold circuit 46, such that a higher threshold is required to switch the device from Area A to Area B, while a lower threshold must be crossed to switch the device from Area B to Area A.

Figure 5 shows another implementation of the capacitive based actuation device 20 of Figure 1 installed in a roof 70 of a vehicle rear the dome light 72. In this case, the detection circuit 27 is configured in a toggle mode (for example, by a toggle circuit in the threshold circuit 46 (Figure 2)). Each time the device is triggered the state of the dome light 72 is inverted. The extra capacitance introduced into the capacitance Cv associated with electrode 34 will either activate or deactivate the dome light 72 depending on its initial state prior to the device being triggered.

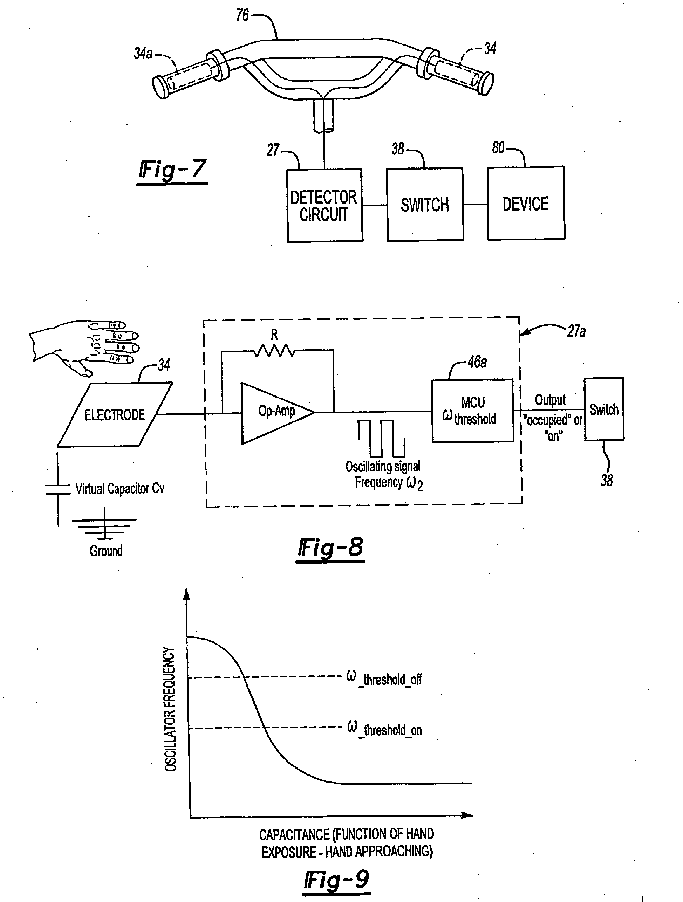

Figures 6 and 7 illustrate a third implementation of the capacitance based human touch activation and switching device 20 of the present invention for determining if an operator of a device 80 is maintaining proper hand contact to continue safe operation. The electrode 34 is mounted in or adjacent a user contact area, such as a user grip area or handle, such as a joystick 74 as shown in Figure 6, handles 76 as shown in Figure 7, or other hand grip or control devices. A second electrode 34a may optionally be used either to require both hands on the handlebars 76, or to require at least one hand on the handles 76. The switch 38 places the device 80 in a deactivated or disabled state until the operator's hand or hands are in position, or signals an alarm indicating that the operator has released the joystick 74 or handles 76. The device 80 may be a power device, such as a vehicle, power tool, machinery or other device where it would be desirable to disable the device if the use removes his hand from the user contact area, such as releasing a handle.

In an alternate detection circuit 27a shown in Figure 8, capacitance is used indirectly as the means of presence detection. The electrode 34 becomes a capacitor in an oscillator. The frequency at which the oscillator functions is dependent on several parameters including the capacitance C. When no hand is present the system will oscillate at a given frequency based on these parameters so long as they remain constant. When a hand is present, the C value increases. If, for example an RC oscillator is used, an increase in capacitance C results in a decrease in oscillating frequency. This phenomenon can be used to determine the presence of an occupant. Other oscillator configurations may have an output in which an increase in capacitance results in an increase in frequency.

A control unit 46a is used to measure the oscillator's frequency and compares the incoming frequency to a set threshold frequency. When no hand is present, the oscillator operates at a fixed frequency based on the capacitance and its surroundings. This known frequency is used to tune the control unit's 46a detection algorithm. A threshold is set on the control unit that will serve to detect the presence of a hand when it is crossed. When the operator places his hand near the electrode 34, the increase in capacitance causes the oscillator frequency to change and cross the set threshold. When the control unit 46a detects the frequency has crossed the threshold, it outputs a signal indicating the presence of a hand. Adjusting the threshold and the surface are of the electrode can control the sensitivity of the device. The threshold determines the amount of change that is necessary to trigger the system. The threshold can be set to require contact with the electrode 34, or it may be set to values that only require the hand to be near the handlebar or joystick. This threshold must be tuned based on the particular application and the surrounding environment. In addition, since the system uses capacitance, the surface area of the electrode plays a role in overall system's sensitivity. The more surface area covered by the electrode, the more sensitive the system will be.

Preferably, the control unit 46a implements hysteresis with respect to the threshold frequency, as is illustrated in the graph of Figure 9, to eliminate flickering of the output signal when the frequency is hovering around the threshold. In the RC oscillator, the operating frequency of the oscillator must cross ω_threshold_on in order for the invention to output an "on" signal. ω_threshold_off is the frequency that must be crossed prior to outputting an "off" signal. These two thresholds can be tuned in the control unit.

The systems utilizing the detection circuit 27a of Figures 8 and 9 can also function as a toggle switch: the control unit 46a can be set to continuously output an "on" signal once the frequency threshold has been crossed. The control unit 46a will continue outputting the "on" signal even if the frequency ceases to cross the threshold. The control unit 46a will then toggle the output to signal "off" if the frequency crosses the threshold once again.

In addition, according to the invention, the control unit 46a can monitor the rate of change of the oscillator's frequency. This allows the control unit 46a to determine how quickly the frequency has changed. Using this method, the control unit 46a can trigger an "on" signal if the rate of change is above a predetermined threshold. This technique can be used in application to determine if the electrode 34 was stricken quickly or if the electrode 34 was only brushed by accident.

The detection circuit 27a and control unit 46a can be used in any of the configurations described with respect to Figures 1, 3, 5, 6 and 7.

Exemplary configurations described above are considered to represent a preferred embodiment of the invention. However, it should be noted that the invention can be practiced otherwise than as specifically illustrated and described without departing from the scope of protection as defined by the appended claims.

## Claims

1. A capacitance based, touch activated switching device comprising:
an electrode (34) forming part of a capacitor, a capacitance of the capacitor changing based upon a presence or absence of an occupant adjacent the electrode (34);
a detection circuit (27a) measuring the capacitance of the capacitor; and
wherein the capacitor is part of an oscillator oscillating at a first frequency when no occupant is present adjacent the electrode (34), and at a second frequency different from the first frequency when the occupant is adjacent the electrode (34), **characterised by** the detection circuit (27a) activating a switch (38) based upon a rate of change in the oscillator frequency.

2. The capacitance based, touch activated switching device of claim 1, wherein the electrode (34) is in a vehicle.

3. The capacitance based, touch activated switching device of claim 2, wherein the electrode (34) is on a vehicle steering wheel (60).

4. The capacitance based, touch activated switching device of claim 2, wherein the switch (38) is for activating a vehicle horn.

5. The capacitance based, touch activated switching device of claim 1, wherein the electrode (34) is mounted adjacent a user manual contact area.

6. The capacitance based, touch activated switching device of claim 1, wherein the electrode (34) is mounted adjacent a user hand grip area.

7. The capacitance based, touch activated switching device of claim 1, wherein the electrode (34) is mounted adjacent a user hand contact area adjacent a user hand contact surface of a power device, the switch (38) deactivating the power device when no user hand is detected near the electrode (34).

8. The capacitance based, touch activated switching device of claim 7, wherein the user hand contact surface is adjacent a user hand grip area.

9. A method for determining the presence of an occupant including the steps of:
a) oscillating an oscillator at a first frequency when no occupant is present adjacent an electrode (34) and oscillating the oscillator at a second frequency different from the first frequency when the occupant is adjacent the electrode (34);
b) measuring a rate of change in oscillator frequency caused by the proximity of the occupant; **characterised by**
c) activating a switch (38) based upon the rate of change measured in step b).

10. The method of claim 9, wherein a vehicle accessory is activated by the switch (38) in said step c).

11. The method of claim 9, wherein a vehicle horn is activated based by the switch (38) in step c).

12. The method of claim 9 , wherein the *switch* (38) is a manual, user-activated switch.

13. The method of claim 12 wherein the switch (38) activates a vehicle accessory (58).

14. The method of claim 13, wherein the vehicle accessory (58) is a vehicle light.

15. The method of claim 13, wherein the vehicle accessory (58) is a vehicle horn.

## Patentansprüche

1. Kapazitive berührungsaktivierte Schaltvorrichtung, umfassend:
eine Elektrode (34), die Teil eines Kondensators ist, wobei eine Kapazität des Kondensators sich aufgrund einer Anwesenheit oder Abwesenheit eines Benutzers in der Nachbarschaft zur Elektrode (34) ändert;
eine Detektionsschaltung (27a), die die Kapazität des Kondensators misst; und
wobei der Kondensator Teil eines Oszillators ist, der mit einer ersten Frequenz schwingt, wenn kein Benutzer in der Nachbarschaft zur Elektrode (34) anwesend ist, und mit einer zweiten Frequenz, die sich von der ersten Frequenz unterscheidet, schwingt, wenn der Benutzer in der Nachbarschaft zur Elektrode (34) ist, **dadurch gekennzeichnet, dass** die Detektionsschaltung (27a) einen Schalter (38) auf der Grundlage einer Änderungsgeschwindigkeit der Oszillatorfrequenz aktiviert.

2. Kapazitive berührungsaktivierte Schaltvorrichtung nach Anspruch 1, wobei die Elektrode (34) in einem Fahrzeug ist.

3. Kapazitive berührungsaktivierte Schaltvorrichtung nach Anspruch 2, wobei die Elektrode (34) an einem Fahrzeuglenkrad (60)vorhanden ist.

4. Kapazitive berührungsaktivierte Schaltvorrichtung nach Anspruch 2, wobei der Schalter (38) zum Aktivieren einer Fahrzeughupe dient.

5. Kapazitive berührungsaktivierte Schaltvorrichtung nach Anspruch 1, wobei die Elektrode (34) in der Nachbarschaft zu einem Anwenderhandkontaktbereich angeordnet ist.

6. Kapazitive berührungsaktivierte Schaltvorrichtung nach Anspruch 1, wobei die Elektrode (34) in Nachbarschaft zu einem Anwenderhandgriffbereich angeordnet ist.

7. Kapazitive berührungsaktivierte Schaltvorrichtung nach Anspruch 1, wobei die Elektrode (34) in der Nachbarschaft zu einem Anwenderhandkontaktbereich in der Nachbarschaft zu einer Anvenderhandkontaktfläche einer kraftbetätigten Vorrichtung angeordnet ist, wobei der Schalter (38) die kraftbetätige Vorrichtung deaktiviert, wenn keine Anwenderhand nahe der Elektrode (34) detektiert wird.

8. Kapazitive berührungsaktivierte Schaltvorrichtung nach Anspruch 7, wobei die Anwenderhandkontaktfläche in der Nachbarschaft zu einem Anwenderhandgriffbereich ist.

9. Verfahren zur Bestimmung der Anwesenheit eines Benutzers mit den folgenden Schritten:
a) Bewirken, dass ein Oszillator mit einer ersten Frequenz schwingt, wenn kein Benutzer in der Nachbarschaft zu einer Elektrode (34) anwesend ist und der Oszillator mit einer zweiten Frequenz, die sich von der ersten Frequenz unterscheidet, schwingt, wenn der Benutzer in der Nachbarschaft zur Elektrode (34) ist;
b) Messen einer Änderungsgeschwindigkeit der Oszillatorfrequenz, die durch die Nähe des Benutzers verursacht wird; **gekennzeichnet durch**
c) Aktivieren eines Schalters (38) auf der Grundlage der in Schritt b) gemessenen Änderungsgeschwindigkeit.

10. Verfahren nach Anspruch 9, wobei ein Fahrzeugzubehör durch den Schalter (38) in dem Schritt c) aktiviert wird.

11. Verfahren nach Anspruch 9, wobei eine Fahrzeughupe durch den Schalter (38) in Schritt c) aktiviert wird.

12. Verfahren nach Anspruch 9, wobei der Schalter (38) ein manueller, anwenderaktivierter Schalter ist

13. Verfahren nach Anspruch 12, wobei der Schalter (38) ein Fahrzeugzubehör (58) aktiviert.

14. Verfahren nach Anspruch 13, wobei das Fahrzeugzubehör (58) eine Fahrzeugleuchte ist.

15. Verfahren nach Anspruch 13, wobei das Fahrzeugzubehör (58) eine Fahrzeughupe ist.

## Revendications

1. Dispositif de commutation activé par le toucher, de type capacitif comprenant :
une électrode (34) faisant partie d'un condensateur, une capacité du condensateur changeant selon la présence ou l'absence d'un occupant proche de l'électrode (34) ;
un circuit de détection (27a) mesurant la capacité du condensateur ; et
dans lequel le condensateur fait partie d'un oscillateur oscillant une première fréquence lorsque aucun occupant n'est présent proche de l'électrode (34), et à une seconde fréquence différente de la première fréquence lorsque l'occupant est proche de l'électrode (34), **caractérisé par** le circuit de détection (27a) activant un commutateur (38) basé sur une vitesse de changement de la fréquence d'oscillateur.

2. Dispositif de commutation activé par le toucher de type capacitif selon la revendication 1, dans lequel l'électrode (34) se situe dans un véhicule.

3. Dispositif de commutation activé par le toucher de type capacitif selon la revendication 2, dans lequel l'électrode (34) se situe sur un volant de véhicule (60).

4. Dispositif de commutation activé par le toucher de type capacitif selon la revendication 2, dans lequel le commutateur (38) sert à activer un klaxon de véhicule.

5. Dispositif de commutation activé par le toucher de type capacitif selon la revendication 1, dans lequel l'électrode (34) est montée proche d'une zone de contact manuelle d'utilisateur.

6. Dispositif de commutation activé par le toucher de type capacitif selon la revendication 1, dans lequel l'électrode (34) est montée proche d'une zone de préhension d'utilisateur.

7. Dispositif de commutation activé par le toucher de type capacitif selon la revendication 1, dans lequel l'électrode (34) est montée proche d'une zone de contact de main d'utilisateur proche d'une surface de contact de main d'utilisateur d'un dispositif de puissance, le commutateur (38) désactivant le dispositif de puissance lorsque aucune main d'utilisateur n'est détectée près de l'électrode (34).

8. Dispositif de commutation activé par le toucher de type capacitif selon la revendication 7, dans lequel la surface de contact de main d'utilisateur est proche d'une zone de préhension d'utilisateur.

9. Procédé pour déterminer la présence d'un occupant comprenant étapes consistant à :
a) faire osciller un oscillateur à une première fréquence lorsque aucun occupant n'est présent près d'une électrode (34) et faire osciller l'oscillateur à une seconde fréquence différente de la première fréquence lorsque l'occupant est près de l'électrode (34) ;
b) mesurer une vitesse de changement de la fréquence d'oscillateur provoquée par la proximité de l'occupant ; **caractérisé par**
c) l'activation d'un commutateur (38) basé sur la vitesse de changement mesurée à l'étape b).

10. Procédé selon la revendication 9, dans lequel un accessoire de véhicule est activé par le commutateur (38) dans ladite étape c).

11. Procédé selon la revendication 9, dans lequel un klaxon de véhicule est activé sur la base du commutateur (38) à l'étape c).

12. Procédé selon la revendication 9, dans lequel le commutateur (38) est un commutateur manuel activé par l'utilisateur.

13. Procédé selon la revendication 12, dans lequel le commutateur (38) active un accessoire de véhicule (58),

14. Procédé selon la revendication 13, dans lequel l'accessoire de véhicule (58) est un feu de véhicule.

15. Procédé selon la revendication 13, dans lequel l'accessoire de véhicule (58) est un klaxon de véhicule.
